Europäisches Patentamt

European Patent Office

Office européen des brevets

(19)

(11) EP 0 587 938 B1

(12) **EUROPÄISCHE PATENTSCHRIFT**

(45) Veröffentlichungstag und Bekanntmachung des Hinweises auf die Patenterteilung:
**13.03.1996 Patentblatt 1996/11**

(51) Int Cl.6: **H03K 19/003**, H03K 19/0185, H03K 3/353

(21) Anmeldenummer: **92116035.4**

(22) Anmeldetag: **18.09.1992**

(54) **Integrierte Pufferschaltung**

Integrated buffer circuit

Circuit tampon intégré

(84) Benannte Vertragsstaaten:
**AT DE FR GB IE IT NL**

(43) Veröffentlichungstag der Anmeldung:
**23.03.1994 Patentblatt 1994/12**

(73) Patentinhaber: **SIEMENS AKTIENGESELLSCHAFT**
**D-80333 München (DE)**

(72) Erfinder:
• **Murphy, Brian, B. Sc.**
**W-8345 Brombach (DE)**

• **Zibert, Martin, Dipl.-Ing.**
**W-8206 Heufeld (DE)**

(56) Entgegenhaltungen:
EP-A- 0 437 039        JP-A- 3 190 421
US-A- 4 086 500        US-A- 5 019 725

• PATENT ABSTRACTS OF JAPAN, Bd. 14, Nr. 476 (E-991)17. Oktober 1990;& JP-A-2195718
• PATENT ABSTRACTS OF JAPAN, Bd. 16, Nr. 403 (E-1254)26. August 1992;& JP-A-4134923
• PATENT ABSTRACTS OF JAPAN, Bd. 8, Nr. 53 (E-231)9. März 1984;& JP-A-58207728
• PATENT ABSTRACTS OF JAPAN, Bd. 3, Nr. 92 (E-128)4. August 1979;& JP-A-5469947
• PATENT ABSTRACTS OF JAPAN, Bd. 14, Nr. 374 (E-964)13. August 1990;& JP-A-2135915

**Beschreibung**

Die Erfindung betrifft eine integrierte Pufferschaltung nach dem Oberbegriff des Patentanspruchs 1.

Pufferschaltungen werden in integrierten Schaltungen häufig benötigt, beispielsweise um Eingangssignale der Schaltkreise an schaltkreis-intern geforderte Signaleigenschaften (z. B. Pegel) anzupaasen oder um Ausgangssignale von Schaltungen an nachfolgende, weitere Schaltungen anzupassen. Nachteilig bei Pufferschaltungen ist bekanntlich ihre Empfindlichkeit gegenüber Störungen (z.B. Rauschen) auf den Leitungen für die Versorgungsspannung. Ihre Funktion ist weiterhin stark abhängig von bei der Versorgungsspannung evtl. auftretenden Spannungsschwankungen, dies insbesondere dann, wenn die Pufferschaltung Signale mit TTL-Pegeln in solche mit CMOS-Pegeln umsetzen soll (TTL-Pegel: 0 V und 2.4 V; CMOS-Pegel meist 0 V und 4 bis 6 V, typisch 5 V).

Aus Patent Abstracts of Japan, Vol. 8, No. 53 (E-231) (1490), March 9, 1984, betreffend die JP-A 58-207 728, ist eine Pufferschaltung mit einem Inverter und einer Konstantstromquelle bekannt. Außerdem ist aus der nachveröffentlichten US-A 5,268,599, die für die am 8. 5. 92 veröffentlichte JP-A 4 134 923 zitiert wird, eine gattungsgemäße Pufferschaltung bekannt. Zwar bewirkt die in diesen beiden Dokumenten vorhandene Konstantstromquelle bereits eine Verringerung der eingangs genannten Empfindlichkeit gegenüber Störungen. Aber dies geschieht nicht in dem oft gewünschten Ausmaß.

Aufgabe der vorliegenden Erfindung ist es deshalb, eine integrierte Pufferschaltung zu schaffen, die weitgehend unabhängig ist von Störungen auf ihrem Eingangssignal und auf den Leitungen für die Versorgungsspannung. Sie soll auch möglichst unempfindlich sein gegenüber Schwankungen der Versorgungsspannung. Weiterhin soll sie sowohl für Eingangssignale mit TTL-Pegeln wie auch für solche mit CMOS-Pegeln geeignet sein, wobei ihr Ausgangssignal jeweils CMOS-Pegel aufweisen soll.

Diese Aufgabe wird bei einer gattungsgemäßen integrierten Pufferschaltung gelöst mit den kennzeichnenden Merkmalen des Patentanspruches 1. Vorteilhafte Aus- und Weiterbildungen sind in Unteransprüchen gekennzeichnet.

Die Erfindung wird nachstehend anhand der Zeichnung näher erläutert. Es zeigen:

| | |
|---|---|
| Die Figuren 1 bis 6, 11, 12 | nicht-beanspruchte Ausbildungen einer integrierten Pufferschaltung, |
| die Figuren 8 und 9 | Potentialdiagramme, |
| die Figur 10 | ein Diagramm als Dimensionierungsbeispiel, |
| und die Figur 7 | eine erfüngsgemäße Pufferschaltung. |

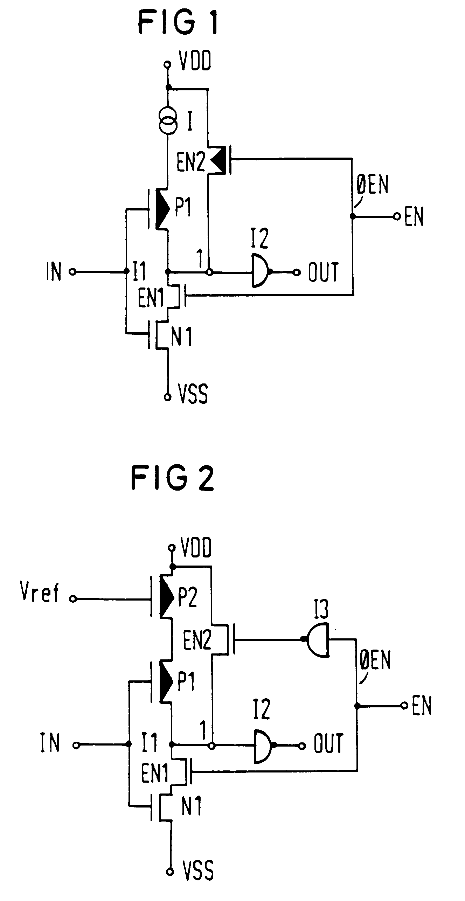

Die Ausführungsform nach Figur 1 enthält zwei hintereinandergeschaltete Inverter I1,I2. Der erste Inverter I1 ist ein CMOS-Inverter mit einem n-Kanal-Transistor N1 und einem p-Kanal-Transistor P1, die in Serie zueinander geschaltet sind. Im Betrieb liegt an ihm über die Gates seiner Transistoren NI,PI ein Eingangssignal IN an. Dieses kann entweder TTL-Pegel aufweisen oder CMOS-Pegel. Am Ausgang des zweiten Inverters I2, der vorzugsweise ebenfalls ein CMOS-Inverter ist, entsteht im Betrieb ein Ausgangssignal OUT der Pufferschaltung. Die beiden Inverter I1,I2 sind über einen Schaltungsknoten 1 sowie über einen ersten Enable-Transistor EN1 miteinander verbunden. Die Source des einen Transistors N1 des ersten Inverters I1 ist mit einem ersten Versorgungspotential VSS (meist gleich 0 V) verbunden. Die Source des anderen Transistors P1 des ersten Inverters I1 ist mit einer Konstantstromquelle I verbunden. Der erste Enable-Transistor EN1 ist dabei zwischen dem Schaltungsknoten 1 und dem n-Kanal-Transistor N1 des ersten Inverters I1 angeordnet. Parallel zu der Anordnung aus Konstantstromquelle I und p-Kanal-Transistor P1 des ersten Inverters I1 ist ein zweiter Enable-Transistor EN2 angeordnet. Die Gates der beiden Enable-Transistoren EN1, EN2 sind gemeinsam mit einem Enable-Eingang EN der Pufferschaltung verbunden. An den Enable-Eingang EN ist im Betrieb ein Enable-Signal ØEN anlegbar.

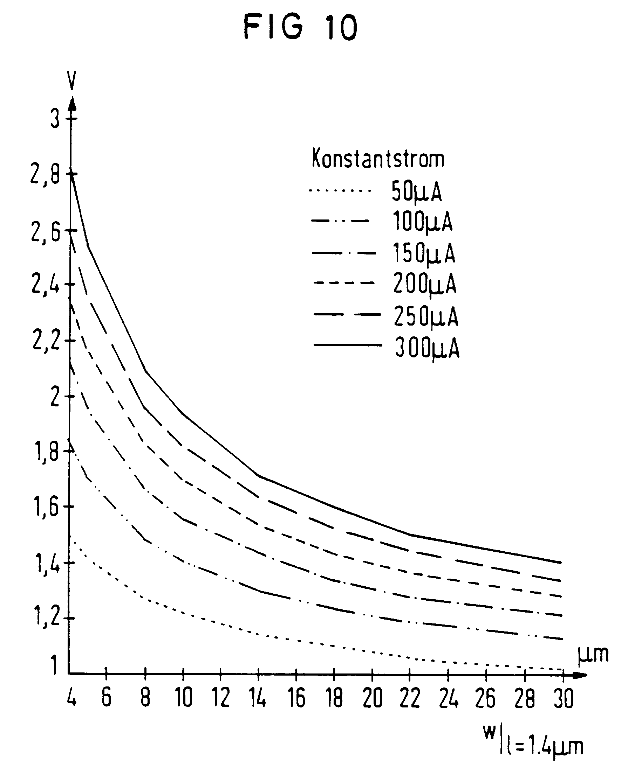

Der Umschaltpunkt des ersten Inverters I1 ist durch geeignete Dimensionierung seines n-Kanal-Transistors N1 festgelegt in Abhängigkeit vom Wert des Stromes der Konstantstromquelle I. Figur 10 zeigt beispielhaft sich ergebende Umschaltpunkte (Ordinate; Maßeinheit: Volt) bei Variation der Kanalweite des einen Transistors N1 (Abszisse; Maßeinheit: μm), wobei verschiedene Stromstärken der Konstantstromquelle I (Maßeinheit: μA) als Parameter angegeben sind und wobei die Kanallänge des n-Kanal-Transistors N1 stets als konstant mit 1,4 μm angenommen ist. Da der erste Inverter I1 ein CMOS-Inverter ist, ist sein Umschaltpunkt in sehr engen Grenzen festgelegt.

Bei leitendem erstem Enable-Transistor EN1 und gesperrtem zweiten Enable-Transistor EN2 ist wegen der Verbindung des p-Kanal-Transistors P1 des ersten Inverters I1 mit der Konstantstromquelle I die Pufferschaltung sehr unempfindlich gegen Störungen und Spannungsschwankungen eines zweiten Versorgungspotentials VDD, das der Konstantstromquelle I als Versorgungsquelle dient. Wegen der Festlegung des Umschaltpunktes des ersten Inverters I1 in sehr engen Grenzen ist die Pufferschaltung gleichfalls unempfindlich gegen Störungen am Eingangssignal IN.

Zu einer weiteren Verringerung der Empfindlichkeit gegenüber Störungen tragen die beiden Enable-Transistoren EN1, EN2 mittels des Enable-Signales ØEN bei: Das Enable-Signal ØEN weist im Betrieb normalerweise einen aktivierten, ersten logischen Pegel auf (in der Ausführungsform nach Figur 1, bei der der erste Enable-Transistor EN1 vom n-Kanal-Typ ist und bei der der zweite Enable-Transistor EN2 vom dazu entgegengesetzten p-Kanal-Typ ist, ist dies ein High-Pegel), bei dem der erste Enable-Transistor EN1 elektrisch leitend geschaltet ist und bei dem der zweite Enable-Transistor EN2 elektrisch sperrt. In diesem Fall liegt am Schaltungsknoten 1 ein durch das Eingangssignal IN und die Dimensionierung des ersten Inverters I1 sowie die Dimensionierung der Konstantstromquelle I bestimmtes Signal an, welches mittels des zweiten Inverters I2 als Ausgangssignal OUT an den Ausgang der Pufferschaltung gelangt.

Wenn nun bekannt ist, daß im Betrieb zu bestimmten Zeitpunkten besonders intensive Störungen zu erwarten sind (beispielsweise bei einem die erfindungsgemäße Pufferschaltung enthaltenden integrierten Halbleiterspeicher mit Adreßmultiplexeinrichtung, welche durch ein Adreßübernahmesignal $\overline{RAS}$ gesteuert ist, verursacht dieses Adreßübernahmesignal $\overline{RAS}$ bei Wechsel seines Pegelzustandes besonders große Störungen auf dem Halbleiterchip), so kann das Enable-Signal ØEN mit einem solchen zeitlichen Verlauf an den Enable-Eingang EN1 angelegt werden, daß es zu Zeitpunkten, zu denen solche Störungen zu erwarten sind, einen inaktivierten, zweiten logischen Pegel aufweist (in der Ausführungsform nach Figur 1 ist dies ein Low-Pegel), während es ansonsten den aktivierten, ersten logischen Pegel aufweist. Bei inaktiviertem Pegel ist dann der erste Enable-Transistor EN1 nunabhängig vom Eingangssignal IN der Pufferschaltung gesperrt, während der zweite Enable-Transistor EN2 elektrisch leitend geschaltet ist, so daß die Wirkung der Konstantstromquelle I und des ersten Inverters I1 aufgehoben sind. In diesem Fall stellt sich am Schaltungsknoten 1 ein Pegel ein mit dem Wert des zweiten Versorgungspotentials VDD, wodurch das Ausgangssignal OUT einen niedrigen Pegel annimmt. Dabei ist angenommen, daß durch den niedrigen Pegel des Ausgangssignals OUT der Pufferschaltung nachgeschaltete, sonstige Schaltungsteile eines integrierten Schaltkreises, welcher die erfindungsgemäße Pufferschaltung enthält, inaktiv geschaltet sind.

Figur 2 zeigt eine vorteilhafte Ausgestaltung der Ausführungsform von Figur 1. Die in Figur 1 gezeigte Konstantstromquelle I enthält nach Figur 2 einen MOS-Transistor P2 vom p-Kanal-Typ. Er ist mit seiner Kanalstrecke zwischen der Source des anderen Transistors P1 des ersten Inverters I1 und dem zweiten Versorgungspotential VDD angeordnet. An seinem Gate liegt im Betrieb ein Referenzpotential $V_{ref}$ an, das einen bezüglich des Wertes des zweiten Versorgungspotentials VDD konstanten Wert aufweist. Verringert sich der Wert des zweiten Versorgungspotentials VDD im Betrieb um einen Betrag $\Delta VDD$, so verringert sich das Referenzpotential $V_{ref}$ um denselben Betrag $\Delta VDD$. Erhöht sich der Wert des zweiten Versorgungspotentials VDD im Betrieb um einen Betrag $\Delta VDD$, so erhöht sich das Referenzpotential $V_{ref}$ um denselben Betrag $\Delta VDD$. Der Wert des Referenzpotentials $V_{ref}$ ist so bemessen, daß der MOS-Transistor P2 bei gesperrtem zweiten Enable-Transistor EN2 elektrisch leitend ist. Die Spannung $U_{GS}$ zwischen Gate und Source des MOS-Transistors P2 ist, entsprechend dem oben Gesagten, konstant. Deshalb fließt im Betrieb ein konstanter Strom $I_{DS}$ über die Kanalstrecke des MOS-Transistors P2; dieser wirkt also als Konstantstromquelle I.

Figur 2 zeigt auch eine weitere Ausführungsform der Enable-Transistoren EN1, EN2: Während in der Ausführungsform nach Figur 1 die Enable-Transistoren EN1, EN2 vom zueinander entgegengesetzten Kanaltyp sind (erster Enable-Transistor EN1: n-Kanal-Typ, zweiter Enable-Transistor EN2: p-Kanal-Typ), sind sie in der Ausführungsform nach Figur 2 vom selben Kanaltyp, nämlich vom n-Kanal-Typ. Zwischen dem Enable-Eingang EN und dem Gate des zweiten Enable-Transistors EN2 ist des weiteren ein dritter Inverter I3 angeordnet, so daß der zweite Enable-Transistor EN2 nach Figur 2 dasselbe Schaltverhalten aufweist hinsichtlich des Enable-Signals ØEN wie der zweite Enable-Transistor EN2 nach Figur 1.

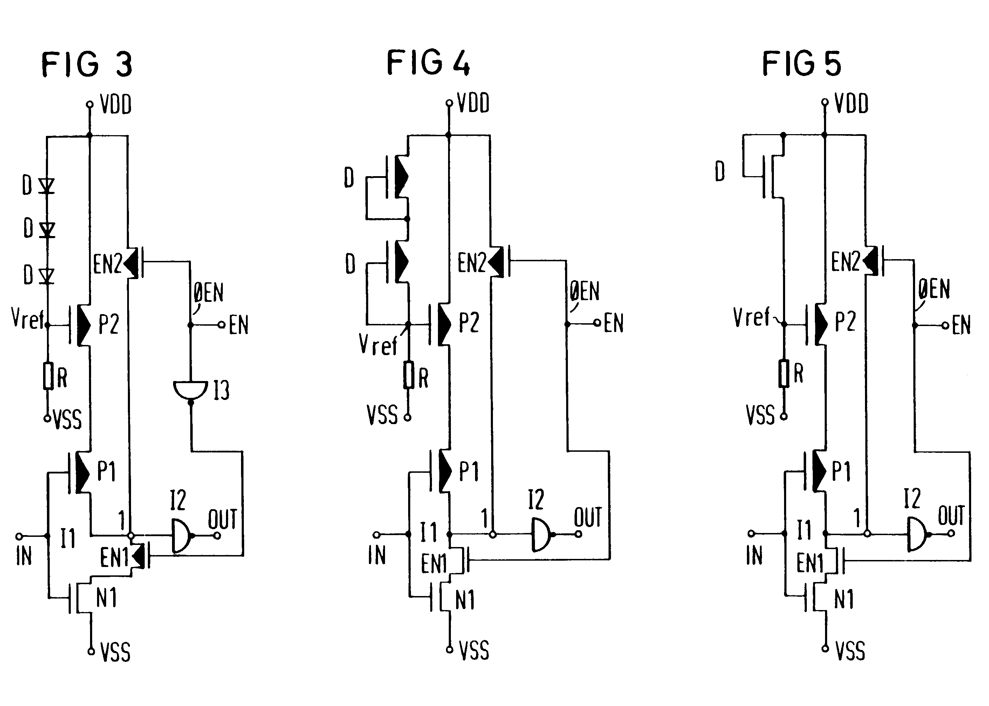

Die Ausführungsform nach Figur 3 zeigt eine Ausgestaltung entsprechend Figur 2, allerdings ergänzt um eine Einrichtung zum Erzeugen des Referenzpotentials $V_{ref}$ und mit Enable-Transistoren EN1, EN2 vom p-Kanal-Typ. Wegen des im Vergleich zu den Enable-Transistoren EN1, EN2 nach Figur 2 entgegengesetzten Schaltverhaltens der Enable-Transistoren EN1, EN2 nach Figur 3 ist der bezüglich Figur 2 genannte dritte Inverter I3 in Figur 3 zwischen dem Enable-Eingang EN und dem Gate des ersten Enable-Transistors EN1 angeordnet.

Die Einrichtung zum Erzeugen des Referenzpotentials $V_{ref}$ nach Figur 3 enthält drei in Serie zueinander geschaltete Dioden D (erfindungsgemäß ist mindestens eine Diode vorgesehen), die zwischen dem zweiten Versorgungspotential VDD und dem Gate des MOS-Transistors P2 angeordnet sind, und einen Widerstand R, der zwischen dem Gate des MOS-Transistors P2 und dem ersten Versorgungspotential VSS angeordnet ist. Der Widerstand R kann selbstverständlich durch ein Widerstandsnetzwerk mit mehreren (in Serie und/ oder parallel geschalteten) Widerständen ersetzt sein.

Der Widerstand R ist so dimensioniert (z.B. 250 kOhm), daß im eingeschwungenen Zustand bezüglich des Eingangssignales IN und bei aktiviertem erstem logischen Pegel des Enable-Signals ØEN ein möglichst geringer Strom zwischen dem zweiten Versorgungspotential VDD und dem ersten Versorgungspotential VSS (über die Dioden D) fließt. Er kann beispielsweise als Implantationswiderstand oder in Form einer hochohmigen Polysiliziumleitung oder als MOS-Transistor mit hohem Kanalwiderstand realisiert sein. Auf diese Weise weist das Referenzpotential $V_{ref}$ stets dieselbe Differenz zum zweiten Versorgungspotential VDD auf, nämlich die Summe $\Sigma V_{thD}$ der Diodenflußspannungen $V_{thD}$ der einzelnen Dioden D.

Die Dioden D sind in der Ausführungsform nach Figur 3 pn-Übergangsdioden. Pn-Übergangsdioden weisen bekanntlich eine gewisse Temperaturabhängigkeit auf, die sich bei den meisten Anwendungen der Pufferschaltung jedoch nicht störend auswirkt.

In der Ausführungsform nach Figur 4 sind die Dioden D als Dioden geschaltete Transistoren (gezeigt sind, im Unterschied zu Figur 3, lediglich zwei Dioden D) vom p-Kanal-Typ. Weiterhin sind die Enable-Transistoren EN1, EN2 vom

EP 0 587 938 B1

entgegengesetzten Kanaltyp entsprechend der Ausführungsform nach Figur 1.

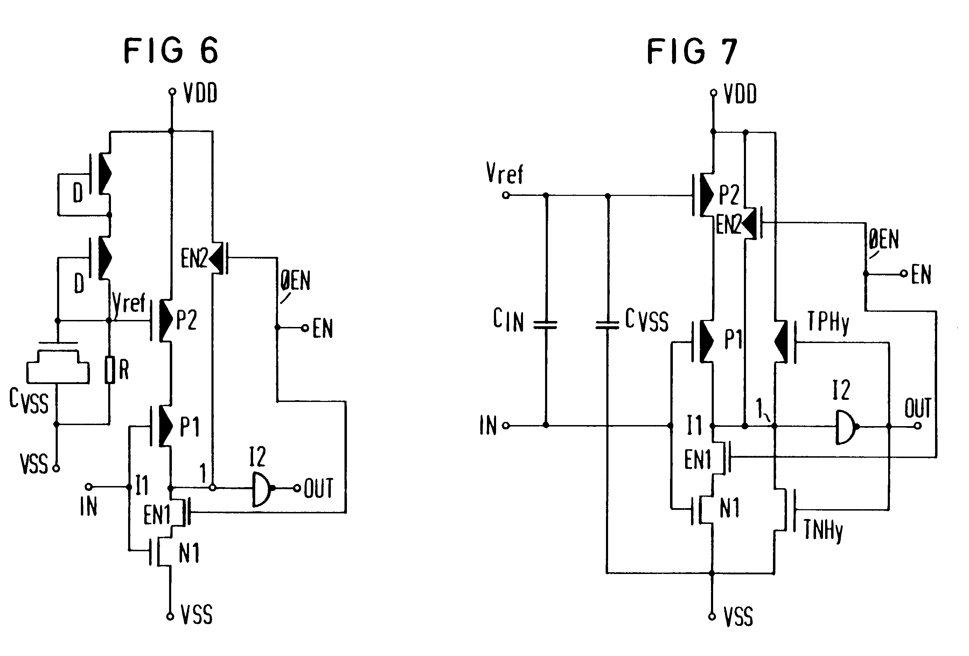

Figur 5 zeigt, anstelle der drei Dioden D nach Figur 3 bzw. anstelle der zwei Dioden D nach Figur 4, eine einzige Diode D in Gestalt eines als Diode geschalteten Transistors vom n-Kanal-Typ.

Für eine Realisierung der Pufferschaltung innerhalb einer integrierten Halbleiterschaltung ist es besonders günstig, die Dioden D in Gestalt von als Dioden geschalteten p-Kanal-Transistoren zu realisieren. Dies hat gegenüber den beiden anderen Ausführungsformen (n-Kanal-Transistoren als Dioden bzw. pn-Übergangsdioden) den Vorteil, daß herstellungsbedingte Schwankungen im MOS-Transistor P2 (Technologieschwankungen und Temperaturabhängigkeit) durch die als Dioden D geschalteten p-Kanal-Transistoren automatisch, herstellungsbedingt ausgeglichen werden.

Die Weiterbildung nach Figur 6 basiert auf der Ausführungsform nach Figur 4. Sie enthält zusätzlich eine erste Kapazität $C_{VSS}$, die zwischen dem Gate des MOS-Transistors P2 und dem ersten Versorgungspotential VSS angeordnet ist. Dies hat den Vorteil, daß Störungen auf dem ersten Versorgungspotential VSS (meist gleich Null Volt, d. h. Masse), die unter ungünstigen Umständen das Schaltverhalten des ersten Transistors N1 des einen Inverters I1 negativ beeinflussen können (Einfluß auf Gate-SourceSpannung $U_{GS}$ dieses Transistors N1) durch die kapazitive Ankopplung des Referenzpotentials $V_{ref}$ an das erste Versorgungspotential VSS (und damit auf die Source des einen Transistors N1 des ersten Inverters I1) weitgehend unterbunden werden, da die kapazitive Ankopplung eine Reduzierung des Kanalstromes $I_{DS}$ im MOS-Transistor P2 bewirkt, die wiederum den Einfluß beim Transistor N1 des ersten Inverters I1 aufhebt. Die erste Kapazität $C_{VSS}$ ist insbesondere dann wichtig, wenn das Eingangssignal IN TTL-Pegel aufweist. Bei einem High-Pegel des Eingangssignales IN von 2.4 V sind nämlich beide Transistoren N1, P1 des ersten Inverters I1 elektrisch leitend (Versorgungspotentiale von VSS = 0 V und VDD = 5 V beispielshaft angenommen). Weist das Eingangssignal IN dagegen CMOS-Pegel auf, so kann die erste Kapazität $C_{VSS}$ durchaus entfallen, ohne die Funktion der Pufferschaltung zu beeinträchtigen, da dann im allgemeinen der Low-Pegel des Eingangssignals IN gleich dem Wert des ersten Versorgungspotentials VSS ist und der High-Pegel des Eingangssignals IN gleich dem Wert des zweiten Versorgungspotentials VDD ist. Es kann auch dann bei Eingangssignalen IN vom TTL-Pegel entfallen, wenn durch andere Maßnahmen sichergestellt ist, daß das erste Versorgungspotential VSS höchstens minimale Störungen aufweisen kann.

Die erfindungs gemäße Pufferschaltung nach Figur 7 zeigt über die Ausführungsform nach Figur 6 hinaus noch weitere vorteilhafte Maßnahmen, die den Betrieb optimieren. Zum einen ist eine zweite Kapazität $C_{IN}$ vorgesehen, die zwischen dem Gate des MOS-Transistors P2 und dem Eingang des ersten Inverters I1 angeordnet ist. Dies bewirkt eine kapazitive Kopplung zwischen dem Referenzpotential $V_{ref}$ und dem Eingangssignal IN und hat (bei aktiviertem Enable-Signal ØEN) kürzere Schaltzeiten des ersten Inverters I1 zur Folge als bei der Ausführungsform nach Figur 6.

Entweder eine der beiden Kapazitäten $C_{VSS}$, $C_{IN}$ oder beide Kapazitäten $C_{VSS}$, $C_{IN}$ können als MOS-Varaktoren ausgebildet sein, d. h. als Transistoren, deren Source und Drain miteinander elektrisch verbunden sind.

Sollte der erste Inverter I1 bezüglich seines Umschaltpunktes so dimensioniert sein, daß (bei aktiviertem Enable-Signal ØEN) an seinem Ausgang, d.h. am Schaltungsknoten 1, ein relativ langsamer Übergang vom High- in den Low-Zustand (oder umgekehrt) erfolgt, so hat dies bei Pegelwerten am Schaltungsknoten 1, die in der Nähe des Umschaltpunktes des zweiten Inverters I2 liegen, zur Folge, daß der zweite Inverter I2 kurzzeitig häufig zwischen Low und High (bzw. umgekehrt) hin- und herschaltet. Dies ist unerwünscht. Dieses unerwünschte Schaltverhalten kann auch auf Störungen am Eingangssignal IN und/oder beim ersten Versorgungspotential VSS beruhen.

In Figur 7 sind deshalb Hysteresetransistoren TNHy, TPHy vorgesehen. Der erste Hysteresetransistor TNHy ist mit seiner Kanalstrecke zwischen dem ersten Versorgungspotential VSS und dem Schaltungsknoten 1 angeordnet. Sein Gate ist mit dem Ausgang der Pufferschaltung verbunden. An ihm liegt also im Betrieb das Ausgangssignal OUT an. Er ist vom n-Kanal-Typ. Der zweite Hysteresetransistor TPHy ist mit seiner Kanalstrecke zwischen dem zweiten Versorgungspotential VDD und dem Schaltungsknoten 1 angeordnet. Das Gate ist ebenfalls mit dem Ausgang der Pufferschaltung verbunden. An ihm liegt also im Betrieb ebenfalls das Ausgangssignal OUT an. Er ist vom p-Kanal-Typ.

Dabei ist es vorteilhaft, wenn der Sättigungsstrom des ersten Hysteresetransistors TNHy kleiner ist als der Strom der Konstantstromquelle I (vorteilhafterweise: maximal 30% des Stromes der Konstantstromquelle I beträgt) und wenn das Verhältnis von Kanalweite zu Kanallänge (w/1) des zweiten Hysteresetransistors TPHy kleiner ist als das entsprechende Verhältnis von Kanalweite zu Kanallänge des einen Transistors N1 des ersten Inverters I1 (vorteilhafterweise: maximal 30 % des Wertes beim Transistor N1 beträgt).

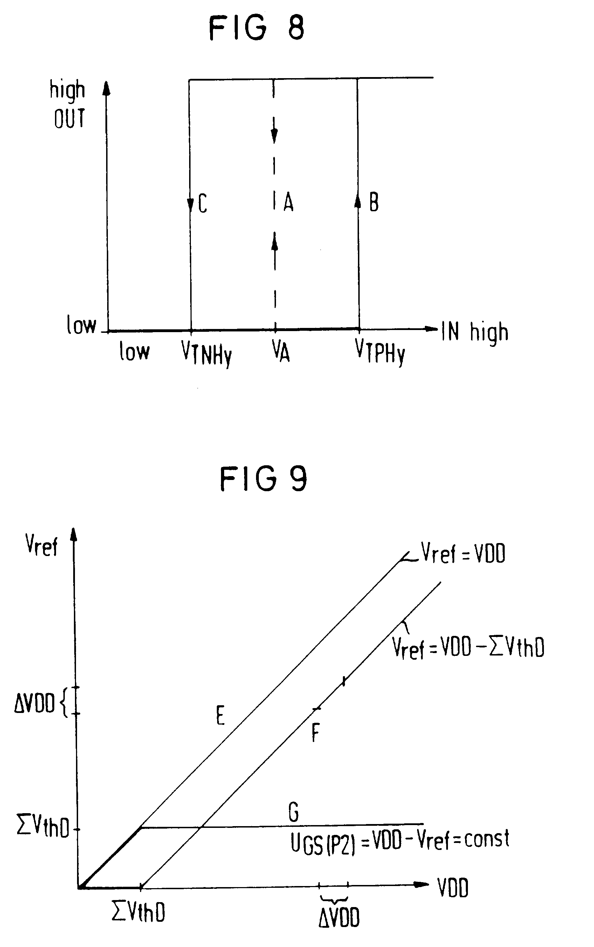

Nachstehend wird die Funktion der Hysteresetransistoren TNHy, TPHy anhand des Diagrammes nach Figur 8 beschrieben, wobei angenommen ist, daß das Enable-Signal ØEN seinen aktivierten, ersten logischen Pegel aufweist. In Figur 8 sind die Werte des Eingangssignals IN gegenüber den Werten des Ausgangssignales OUT der Pufferschaltung bezüglich verschiedener Aus führungs formen der Pufferschaltung als Kurven aufgetragen. Das Ansteigen und Abfallen des Eingangssignals IN ist jeweils mit einem Pfeil in den Kurven dargestellt.

Eine Kurve A (gestrichelt gezeichnet) zeigt das Schaltverhalten einer Pufferschaltung ohne Hysteresetransistoren TPHy, TNHy. Die Umschaltpunkte der Pufferschaltung für die Übergänge von Low auf High und von High auf Low des Ausgangssignales OUT liegen beide bei einem Wert $V_A$ des Eingangssignals IN.

Wenn derart große Störungen an den Versorgungspotentialen VSS, VDD und/oder am Eingangssignal IN zu erwarten sind, daß sie einen unerwünschten Übergang des Ausgangssignals OUT vom Low- in den High-Zustand zur

4

Folge haben können (wobei angenommen ist, daß diese Störungen zeitlich nicht vorhersehbar sind, so daß dem Enable-Signal ØEN nicht der deaktivierte, zweiten logische Pegel zuordenbar ist), so empfiehlt es sich, den zweiten Hysteresetransistor TPHy nach Figur 8 vorzusehen (Kurven A und B). Dies bewirkt, daß bei Ansteigen des Eingangssignals IN das Ausgangssignal OUT seinen High-Wert erst bei einem Wert von $V_{TPHy}$ (Kurve B) des Eingangssignals IN annimmt, der höher ist als der Wert $V_A$ des Eingangssignals IN einer Pufferschaltung ohne diesen Hysteresetransistor (beispielsweise 0,1 bis 0,4 V höher). Für ein Ansteigen des Wertes des Eingangssignales IN (Pfeil in Kurve B) wird also der Umschaltpunkt der Pufferschaltung in Richtung größere Werte des Eingangsignals IN verschoben. Für ein Abfallen des Wertes des Eingangssignals IN (Pfeil nach unten in Kurve A) von High in Richtung Low bleibt der Umschaltpunkt der Pufferschaltung unverändert beim Wert $V_A$ des Eingangssignals IN (entsprechend einer Pufferschaltung ohne Hysteresetransistoren).

Wenn hingegen (ebenfalls zeitlich nicht vorhersehbar, s.o.) derart große Störungen an den Versorgungspotentialen VSS, VDD und/oder am Eingangssignal IN zu erwarten sind, daß sie einen unerwünschten Übergang des Ausgangssignales OUT vom High- in den Low-Zustand zur Folge haben können, so empfiehlt es sich, den ersten Hysteresetransistor TNHy vorzusehen (Kurven A und C). Dies bewirkt, daß bei Ansteigen des Eingangssignals IN das Ausgangssignal OUT seinen High-Wert unverändert beim Wert $V_A$ (Pfeil nach oben in Kurve A; entspricht einer Pufferschaltung ohne Hysteresetransistoren) des Eingangssignals IN annimmt. Für ein Abfallen des Wertes des Eingangssignals IN (Pfeil nach unten in Kurve C) von High in Richtung Low wird der Umschaltpunkt der Pufferschaltung jedoch auf einen Wert $V_{TNHy}$ in Richtung kleinere Werte des Eingangssignals IN verschoben (beispielsweise um 0,1 bis 0,4 V nach unten).

Sind jedoch entsprechende Störungen zu erwarten, die unerwünschte Übergänge des Ausgangssignals OUT sowohl beim Übergang vom High- in den Low-Zustand wie auch umgekehrt zur Folge haben können, so ist der Einsatz beider Hysteresetransistoren TPHy, TNHy vorteilhaft, wie in Figur 7 dargestellt (Kurven B und C in Figur 8). Dies bewirkt, daß bei Ansteigen des Eingangssignals IN das Ausgangssignal OUT seinen High-Wert erst bei dem Wert vom $V_{TPHy}$ (Kurve B) des Eingangssignals IN annimmt, der höher ist als der Wert $V_A$ des Eingangssignals IN einer Pufferschaltung ohne Hysteresetransistoren (beispielsweise 0,1 bis 0,4 V höher). Für ein Ansteigen des Wertes des Eingangssignals IN (Pfeil in Kurve B) wird also der Umschaltpunkt der Pufferschaltung in Richtung größere Werte des Eingangssignals IN verschoben. Ebenso wird bei einem Abfallen des Wertes des Eingangssignales IN (Pfeil nach unten in Kurve C) von High in Richtung Low der Umschaltpunkt der Pufferschaltung auf den Wert $V_{TNHy}$ in Richtung kleinere Werte des Eingangssignals IN verschoben gegenüber einer Pufferschaltung ohne Hysteresetransistoren (beispielsweise um 0,1 bis 0,4 V nach unten).

Figur 9 zeigt den Wert des Referenzpotentials $V_{ref}$ der Pufferschaltungen für Dioden D nach den Figuren 3 bis 6, aufgetragen gegenüber dem zweiten Versorgungspotential VDD (Kurve F). Sein Verlauf ist bei den Ausführungsformen nach den Figuren 2 und 7 qualitativ identisch, er ist lediglich in seinem quantitativen Verlauf gegebenenfalls unterschiedlich, da in den Ausführungsformen nach den Figuren 2, 7 keine Dioden gezeigt sind.

Eine Kurve E zeigt den hypothetischen Verlauf eines Referenzpotentials $V'_{ref}$, der sich ergäbe für eine Bedingung $V'_{ref}$ = VDD. Dieser Fall ist nach der vorliegenden Lehre tatsächlich ausgeschlossen, denn die Pufferschaltung würde nicht funktionieren, da der MOS-Transistor P2 stets im gesperrten Zustand wäre. Die Kurve E dient lediglich dazu, den Verlauf der Kurve F anschaulicher darstellen zu können: Kurve F zeigt den tatsächlichen Verlauf des Referenzpotentials $V_{ref}$ gegenüber dem zweiten Versorgungspotential VDD.

Zunächst steigt (bei Inbetriebnahme der Pufferschaltung) das zweite Versorgungspotential VDD an bis zu einem Wert, der der Summe $\Sigma v_{thD}$ aller Flußspannungen der Dioden D entspricht. Bis zu diesem Punkt beträgt der Wert des Referenzpotentials $V_{ref}$ stets 0 V. Die Gate-Source-Spannung $U_{GS(P2)}$ am MOS-Transistor P2 (dargestellt in Kurve G) steigt, parallel zum Ansteigen des zweiten Versorgungspotentials VDD, an bis zum Wert $\Sigma V_{thD}$. Wenn nun im weiteren Verlauf der Wert des zweiten Versorgungspotentials VDD diesen Summenwert $\Sigma V_{thD}$ übersteigt, so steigt das Referenzpotential $V_{ref}$ an mit einem Wert, der stets gleich ist dem jeweils aktuellen Wert des zweiten Versorgungspotentials VDD abzüglich des Summenwertes $\Sigma V_{thD}$, so daß stets gilt: $V_{ref}$ = VDD-$\Sigma V_{thD}$. Demzufolge gilt für diesen Bereich für die Gate-Source-Spannung $U_{GS(P2)}$ am MOS-Transistor P2 stets die Gleichung

$$U_{GS(P2)} = VDD - V_{ref} = VDD - (VDD-\Sigma V_{thD}) = \Sigma V_{thD}.$$

Dieser Wert ist konstant. Wenn nun, wie erfindungsgemäß vorgesehen, der Summenwert $\Sigma V_{thD} \geq$ dem Wert der Einsatzspannung $V_{thP2}$ des MOS-Transistors P2 ist, so fließt über die Kanalstrecke des MOS-Transistors P2 stets ein konstanter Strom $I_{DS}$; der MOS-Transistor P2 wirkt als Konstantstromquelle I.

Figur 9 zeigt auch, daß sich in dem Fall, indem sich der Wert des zweiten Versorgungspotentials VDD um einen Betrag $\Delta$VDD ändert (z. B. durch einen Spannungseinbruch oder, wie dargestellt, beim Anstieg des zweiten Versorgungspotentials VDD), der Wert des Referenzpotentials $V_{ref}$ um denselben Betrag $\Delta$VDD ändert.

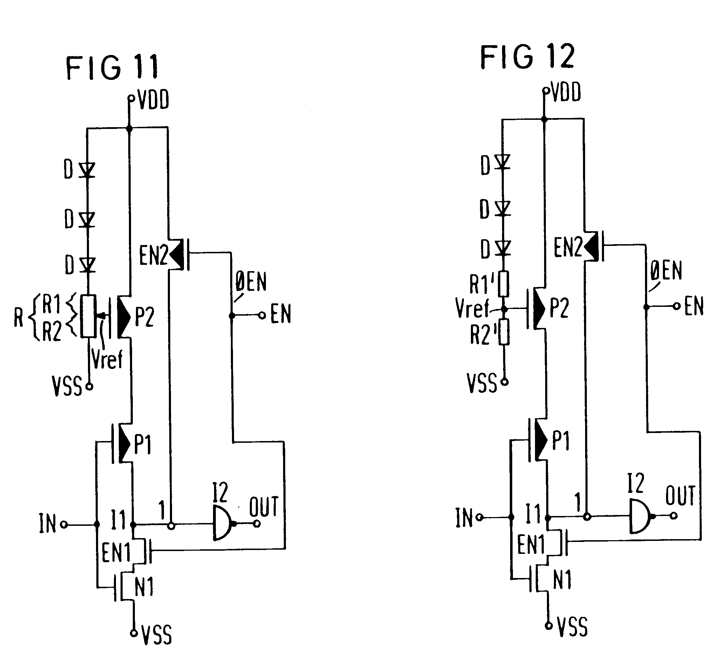

Figur 11 zeigt eine weitere Ausführungsform einer Pufferschaltung. Sie basiert auf der Ausführungsform nach Figur 3 mit folgenden Änderungen: Zum einen sind die beiden Enable-Transistoren EN1, EN2 vom zueinander entgegengesetzten Kanaltyp, wie bereits anhand von Figur 1 beschrieben. Zum anderen ist der Widerstand R nicht zwischen dem Gate des MOS-Transistors P2 und dem ersten Versorgungspotential VSS angeordnet (wie bei Figur 3), sondern zwischen den Dioden D und dem ersten Versorgungspotential VSS. Der Widerstand R ist nach Art eines Potentiometers ausgestaltet mit einem Widerstandsabgriff, der mit dem Gate des MOS-Transistors P2 verbunden ist. Der Widerstand R zerfällt somit funktionell in zwei Widerstandsanteile R1, R2. Der erste Widerstandsanteil R1 ist dabei zwischen den Dioden D und dem mit dem Gate des MOS-Transistors P2 verbundenen Widerstandsabgriff angeordnet, während der zweite Widerstandsanteil R2 zwischen diesem Widerstandsabgriff und dem ersten Versorgungspotential VSS angeordnet ist.

Mit dieser Anordnung läßt sich durch geeignetes Positionieren des Widerstandsabgriffes am Widerstand R der gewünschte Wert des Referenzpotentials $V_{ref}$ genauer einstellen als allein durch Auswählen einer geeigneten Anzahl von Dioden D mit ihren Diodenflußspannungen $V_{thD}$.

Eine technisch gleichwertige Lösung ergibt sich auch, wenn man anstelle des Widerstandes R mit seinen beiden Widerstandsanteilen R1, R2 wenigstens zwei separate, in Serie geschaltete Widerstände R1', R2' vorsieht, wobei der eine Widerstand R1' zwischen den Dioden D und dem Gate des MOS-Transistors P2 angeordnet ist, während der andere Widerstand R2' zwischen dem Gate des MOS-Transistors P2 und dem ersten Versorgungspotential VSS angeordnet ist (siehe Figur 12).

**Patentansprüche**

1. Integrierte Pufferschaltung mit einem ersten Inverter (I1) und einer Konstantstromquelle (I) mit folgenden Merkmalen:

   - der erste Inverter (I1) weist einen Ausgang auf, der ein Schaltungsknoten (1) ist,
   - der erste Inverter (I1) ist ein CMOS-Inverter und enthält wenigstens zwei über den Schaltungsknoten (1) in Serie zueinander geschaltete Transistoren (N1, P1), wobei der eine Transistor (N1) von einem anderen Kanaltyp ist als der andere Transistor (P1),
   - die Gates der Transistoren (N1, P1) des ersten Inverters (I1) sind elektrisch miteinander verbunden als Eingang des ersten Inverters (I1), wobei dieser Eingang mit einem Eingangssignal (IN) beaufschlagbar ist,
   - die Source des anderen Transistors (P1) des ersten Inverers (I1) ist mit der Konstantstromquelle (I) verbunden,
   - es sind ein erster (EN1) und ein zweiter (EN2) Enable-Transistor vorgesehen,
   - parallel zu der aus der Konstantstromquelle (I) und dem anderen Transistor (P1) des ersten Inverters (I1) gebildeten Anordnung ist der zweite Enable-Transistor (EN2) mit seinem stromführenden Pfad angeordnet,
   - die Gates der Enable-Transistoren (EN1, EN2) sind mit einem Enable-Eingang (EN) der Pufferschaltung verbunden,

   **dadurch gekennzeichnet**,

   daß die integrierte Pufferschaltung wenigstens einen zweiten Inverter (I2) enthält, der in Serie zum ersten Inverter (I1) geschaltet ist, wobei ein Ausgang des zweiten Inverters (I2) für ein Ausgangssignal (OUT) der Pufferschaltung vorgesehen ist und wobei zwischen den beiden Invertern (I1, I2) der Schaltungsknoten (1) angeordnet ist,
   daß die Source des einen Transistors (N1) des ersten Inverters (I1) mit einem ersten Versorgungspotential (VSS) verbunden ist,
   daß zwischen der Drain des einen Transistors (N1) des ersten Inverters (I1) und dem Schaltungsknoten (1) der erste Enable-Transistor (EN1) mit seinem stromführenden Pfad angeordnet ist
   und daß zwischen dem Schaltungsknoten (1) und dem ersten Versorgungspotential (VSS) ein erster Hysterese-Transistor (TNHy) mit seiner Kanalstrecke angeordnet ist, dessen Gate mit dem Ausgang des zweiten Inverters (I2) verbunden ist.

2. Integrierte Pufferschaltung nach Anspruch 1,
   **dadurch gekennzeichnet**, daß die Konstantstromquelle (I) einen MOS-Transistor (P2) enthält, der zwischen der Source des anderen Transistors (P1) des ersten Inverters (I1) und einem zweiten Versorgungspotential (VDD) angeordnet ist, der im Betrieb elektrisch leitend ist und an dessen Gate im Betrieb ein Referenzpotential ($V_{ref}$) anliegt mit einem Wert, der eine konstante Differenz zum Wert des zweiten Versorgungspotentials (VDD) aufweist.

3. Integrierte Pufferschaltung nach Anspruch 2,

**dadurch gekennzeichnet**, daß der MOS-Transistor (P2) vom p-Kanal-Typ ist.

4. Integrierte Pufferschaltung nach Anspruch 2 oder 3,
**dadurch gekennzeichnet** , daß zur Erzeugung des Referenzpotentials ($V_{ref}$) wenigstens ein Widerstand (R) und wenigstens eine Diode (D) vorgesehen sind, daß die wenigstens eine Diode (D) zwischen dem Gate des MOS-Transistors (P2) und dem zweiten Versorgungspotential (VDD) angeordnet ist und daß der Widerstand (R) zwischen dem Gate des MOS-Transistors (P2) und dem ersten Versorgungspotential (VSS) angeordnet ist.

5. Integrierte Pufferschaltung nach Anspruch 2 oder 3,
**dadurch gekennzeichnet**,

- daß zur Erzeugung des Referenzpotentials ($V_{ref}$) wenigstens ein Widerstand (R) nach Art eines Potentiometers und wenigstens eine Diode (D) vorgesehen sind, wobei der Widerstand (R) einen ersten Widerstandsanteil (R1) und einen zweiten Widertstandsanteil (R2) aufweist,
- daß beide Widerstandsanteile (R1, R2) an ihrem dem jeweiligen anderen Widerstandsanteil (R2; R1) zugewandten Ende mit dem Gate des MOS-Transistors (P2) verbunden sind als Potentialabgriff vom Widerstand (R),
- daß die wenigstens eine Diode (D) zwischen dem ersten Widerstandsanteil (R1) und dem zweiten Versorgungspotential (VDD) angeordnet ist und
- daß der zweite Widerstandsanteil (R2) mit dem ersten Versorgungspotential (VSS) verbunden ist.

6. Integrierte Pufferschaltung nach Anspruch 2 oder 3,
**dadurch gekennzeichnet**,

- daß zur Erzeugung des Referenzpotentials ($V_{ref}$) wenigstens zwei Widerstände (R1', R2') und wenigstens eine Diode (D) vorgesehen sind,
- daß beide Widerstände (R1', R2') an ihrem dem jeweiligen anderen Widerstand (R2'; R1') zugewandten Ende mit dem Gate des MOS-Transistors (P2) verbunden sind,
- daß die wenigstens eine Diode (D) zwischen dem ersten Widerstand (R1') und dem zweiten Versorgungspotential (VDD) angeordnet ist und
- daß der zweite Widerstand (R2') mit dem ersten Versorgungspotential (VSS) verbunden ist.

7. Integrierte Pufferschaltung nach einem der Ansprüche 4 bis 6, **dadurch gekennzeichnet**, daß die Diode (D) eine pn-Übergangsdiode ist.

8. Integrierte Pufferschaltung nach einem der Ansprüche 4 bis 6, **dadurch gekennzeichnet**, daß die Diode (D) ein als Diode geschalteter Transistor ist.

9. Integrierte Pufferschaltung nach einem der Ansprüche 2 bis 8, **dadurch gekennzeichnet**, daß zwischen dem Gate des MOS-Transistors (P2) und dem ersten Versorgungspotential (VSS) eine erste Kapazität ($C_{VSS}$) angeordnet ist.

10. Integrierte Pufferschaltung nach einem der Ansprüche 2 bis 9, **dadurch gekennzeichnet**, daß zwischen dem Eingang des ersten Inverters (I1) und dem Gate des MOS-Transistors (P2) eine zweite Kapazität ($C_{IN}$) angeordnet ist.

11. Integrierte Pufferschaltung nach Anspruch 9 oder 10, **dadurch gekennzeichnet**, daß wenigstens eine der Kapazitäten ($C_{VSS}$, $C_{IN}$) ein MOS-Varaktor ist.

12. Integrierte Pufferschaltung nach einem der vorhergehenden Ansprüche, **dadurch gekennzeichnet**, daß der erste Hysteresetransistor (TNHy) vom n-Kanal-Typ ist.

13. Integrierte Pufferschaltung nach einem der vorhergehenden Ansprüche, **dadurch gekennzeichnet**, daß der erste Hysteresetransistor (TNHy) einen Sättigungsstrom aufweist, der kleiner ist als der Strom der Konstantstromquelle (I).

14. Integrierte Pufferschaltung nach einem der vorhergehenden Ansprüche,
**dadurch gekennzeichnet**, daß zwischen dem Schaltungsknoten (1) und dem zweiten Versorgungspotential (VDD) ein zweiter Hysteresetransistor (TPHy) mit seiner Kanalstrecke angeordnet ist, dessen Gate mit dem Ausgang des zweiten Inverters (I2) verbunden ist.

**15.** Integrierte Pufferschaltung nach Anspruch 14,
**dadurch gekennzeichnet**, daß der zweite Hysteresetransistor (TPHy) vom p-Kanal-Typ ist.

**16.** Integrierte Pufferschaltung nach Anspruch 14 oder 15,
**dadurch gekennzeichnet**, daß der zweite Hysteresetransistor (TPHy) ein Verhältnis von Kanalweite zu Kanallänge aufweist, das kleiner ist als das Verhältnis von Kanalweite zu Kanallänge des einen Transistors (N1) des ersten Inverters (I1).

**17.** Integrierte Pufferschaltung nach einem der vorhergehenden Ansprüche
**dadurch gekennzeichnet**, daß die Enable-Transistoren (EN1, EN2) vom zueinander entgegengesetzten Kanaltyp sind.

**18.** Integrierte Pufferschaltung nach einem der Ansprüche 1 bis 16,
**dadurch gekennzeichnet**, daß die Enable-Transistoren (EN1, EN2) vom selben Kanaltyp sind und daß zwischen dem Enable-Eingang (EN) und dem Gate eines (EN2; EN1) der beiden Enable-Transistoren (EN1, EN2) ein dritter Inverter (I3) angeordnet ist.

**Claims**

**1.** Integrated buffer circuit having a firet inverter (I1) and a constant-current source (I) and having the following features:

- the first inverter (I1) has an output which is a circuit node (1),
- the first inverter (I1) is a CMOS inverter and contains at least two transistors (N1, P1) connected in series via the circuit node (1), one transistor (N1) being of a different channel type than the other transistor (P1),
- the gates of the transistors (N1, P1) of the first inverter (I1) are connected to one another electrically as input of the first inverter (I1), it being possible to apply an input signal (IN) to this input,
- the source of the other transistor (P1) of the first inverter (I1) is connected to the constant-current source (I),
- a first (EN1) and second (EN2) enable transistor are provided,
- the second enable transistor (EN2) with its current-carrying path is arranged in parallel with the arrangement formed from the constant-current source (I) and the other transistor (P1) of the first inverter (I1),
- the gates of the enable transistors (EN1, EN2) are connected to an enable input (EN) of the buffer circuit,

characterized in that the integrated buffer circuit contains at least one second inverter (I2) which is connected in series with the first inverter (I1), one output of the second inverter (I2) being provided for an output signal (OUT) of the buffer circuit, and the circuit node (1) being arranged between the two inverters (I1, I2), in that the source of one transistor (N1) of the first inverter (I1) is connected to a first supply potential (VSS), in that the first enable transistor (EN1) with its current-carrying path is arranged between the drain of one transistor (N1) of the first inverter (I1) and the circuit node (1) and in that between the circuit node (1) and the first supply potential (VSS) there is arranged a first hysteresis transistor (TNHy) with its channel section, whose gate is connected to the output of the second inverter (I2) .

**2.** Integrated buffer circuit according to claim 1, characterized in that the constant-current source (I) contains an MOS transistor (P2) which is arranged between the source of the other transistor (P1) of the first inverter (I1) and a second supply potential (VDD) which is electrically conducted during operation and to whose gate a reference potential ($v_{ref}$) is applied during operation with a value which as a constant difference relative to the value of the second supply potential (VDD).

**3.** Integrated buffer circuits according to Claim 2, characterized in that the MOS transistor (P2) is of the p-channel type.

**4.** Integrated buffer circuit according to Claim 2 or 3, characterized in that at least one resistor (R) and at least one diode (D) are provided for generating the reference potential ($v_{ref}$), in that the at least one diode (D) is arranged between the gate of the MOS transistor (P2) and the second supply potential (VDD) and in that the resistor (R) is arranged between the gate of the MOS transistor (P2) and the first supply potential (VSS).

**5.** Integrated buffer circuit according to Claim 2 or 3, characterized in that

- at least one resistor (R) of the type of a potentiometer and at least one diode (D) are provided for generating the reference potential ($v_{ref}$), the resistor (R) having a first resistance component (R1) and a second resistance component (R2),

- at their end facing the respective other resistance component (R2; R1) the two resistance components (R1, R2) are connected to the gate of a MOS transistor (P2) as potential tap from the resistor (R),
- the at least one diode (D) is arranged between the first resistance component (R1) and the second supply potential (VDD), and
- in that the second resistance component (R2) is connected to the first supply potential (VSS).

6. Integrated buffer circuit according to Claim 2 or 3, characterized in that

- at least two transistors (R1', R2') and at least one diode (D) are provided for generating the reference potential ($V_{ref}$),
- at their end facing the respective other resistor (R2'; R1') the two resistors (R1', R2') are connected to the gate of the MOS transistor (P2),
- the at least one diode (D) is arranged between the first resistor (R1') and the second supply potential (VDD), and
- in that the second resistor (R2') is connected to the first supply potential (VSS).

7. Integrated buffer circuit according to one of Claims 4 to 6, characterized in that the diode (D) is a pn-junction diode.

8. Integrated buffer circuit according to one of Claims 4 to 6, characterized in that the diode (D) is a transistor connected as a diode.

9. Integrated buffer circuit according to one of Claims 2 to 8, characterized in that a first capacitor ($C_{VSS}$) is arranged between the gate of the MOS transistor (P2) and the first supply potential (VSS).

10. Integrated buffer circuit according to one of Claims 2 to 9, characterized in that a second capacitor ($C_{IN}$) is arranged between the input of the first inverter (I1) and the gate of the MOS transistor (P2).

11. Integrated buffer circuit according to Claim 9 or 10, characterized in that at least one of the capacitors ($C_{VSS}$, $C_{IN}$) is an MOS varactor.

12. Integrated buffer circuit according to one of the preceding claims, characterized in that the first hysteresis transistor (TNHy) is of n-channel type.

13. Integrated buffer circuit according to one of the preceding claims, characterized in that the first hysteresis transistor (TNHy) has a saturation current which is smaller than the current of the constant-current source (I).

14. Integrated buffer circuit according to one of the preceding claims, characterized in that between the circuit node (1) and the second supply potential (VDD) there is arranged a second hysteresis transistor (TPHy) with its channel section, whose gate is connected to the output of the second inverter (I2).

15. Integrated buffer circuit according to Claim 14, characterized in that the second hysteresis transistor (TPHy) is of the p-channel type.

16. Integrated buffer circuit according to Claim 14 or 15, characterized in that the second hysteresis transistor (TPHy) has a ratio of channel width to channel length which is smaller than the ratio of channel width to channel length of one transistor (N1) of the first inverter (I1).

17. Integrated buffer circuit according to one of the preceding claims, characterized in that the enable transistors (EN1, EN2) are of mutually opposite channel type.

18. Integrated buffer circuit according to one of Claims 1 to 16, characterized in that the enable transistors (EN1, EN2) are of the same channel type, and in that a third inverter (I3) is arranged between the enable input (EN) and the gate of one (EN2; EN1) of the two enable transistors (EN1, EN2).

**Revendications**

1. Circuit tampon intégré comportant un premier inverseur (II) et une source de courant constant (I), présentant les caractéristiques suivantes :

    - le premier inverseur (I1) possède une sortie, qui est un noeud (1) du circuit,
    - le premier inverseur (I1) est un inverseur CMOS et comporte au moins deux transistors (N1,P1), qui sont branchés en série par l'intermédiaire du noeud (1) du circuit, le premier transistor (N1) possédant un canal d'un autre type que celui de l'autre transistor (P1),
    - les grilles des transistors (N1,P1) du premier inverseur (I1) sont reliées électriquement entre elles en tant qu'entrée du premier inverseur (II), cette entrée pouvant être chargée par un signal d'entrée (IN),
    - la source de l'autre transistor (P1) du premier inverseur (I1) est reliée à la source de courant constant (I),
    - il est prévu un premier transistor Enable (transistor de validation) (EN1) et un second transistor Enable (EN2),
    - la voie qui transmet le courant du second transistor Enable (EN2), est disposée en parallèle avec le dispositif formé par la source de courant constant (I) et l'autre transistor (P) du premier inverseur (I1),
    - les grilles des transistors Enable (EN1,EN2) sont reliées à une entrée Enable (EN) du circuit tampon,

    présentant les particularités suivantes :

    le circuit tampon intégré possède au moins un second inverseur (I2), qui est branché en série avec le premier inverseur (I1), une sortie du second inverseur (I2) étant prévue pour un signal de sortie (OUT) du circuit tampon, tandis que le noeud (1) du circuit est disposé entre les deux inverseurs (I1,I2),
    la source d'un transistor (N1) du premier inverseur (II) est reliée à un premier potentiel d'alimentation (VSS),
    la voie, qui transmet le courant, du premier transistor Enable (EN1) est disposée entre le drain d'un transistor (N1) du premier inverseur (I1) et le noeud (1) du circuit,
    et
    entre le noeud (1) du circuit et le premier potentiel d'alimentation (VSS) est disposée la section de canal d'un premier transistor à hystérèse (DNHy), dont la grille est reliée à la sortie du second inverseur (I2).

2. Circuit tampon intégré suivant la revendication 1, caractérisé par le fait que la source de courant constant (I) comporte un transistor MOS (P2), qui est disposé entre la source de l'autre transistor (P1) du premier inverseur (I1) et un second potentiel d'alimentation (VDD), et qui est électriquement conducteur en fonctionnement et à la grille duquel est appliqué, en fonctionnement, un potentiel de référence ($V_{ref}$), qui possède une valeur qui présente une différence constante par rapport à la valeur du second potentiel d'alimentation (VDD).

3. Circuit tampon intégré suivant la revendication 2, caractérisé par le fait que le transistor MOS (P2) est du type à canal p.

4. Circuit tampon intégré suivant la revendication 2 ou 3, caractérisé par le fait que pour la production du potentiel de référence ($V_{ref}$), il est prévu au moins une résistance (R) et au moins une diode (D), que la ou les diodes (D) sont disposées entre la grille du transistor MOS (P2) et le second potentiel d'alimentation (VDD), et que la résistance (R) est disposée entre la grille du transistor MOS (P2) et le premier potentiel d'alimentation (VSS).

5. Circuit tampon intégré suivant la revendication 2 ou 3, caractérisé par le fait

    - que pour la production du potentiel de référence ($V_{ref}$) il est prévu au moins une résistance (R) réalisée à la manière d'un potentiomètre, et au moins une diode (D), la résistance (R) possédant une première composante (R1) et une seconde composante (R2),
    - que les deux composantes (R1,R2) de la résistance sont reliées, par leur extrémité tournée vers respectivement l'autre composante (R2;R1) de la résistance, à la grille du transistor MOS (P2), de manière à former la prise de potentiel de la résistance (R),
    - que la ou les diodes (D) sont disposées entre la première composante (R1) de la résistance et le second potentiel d'alimentation (VDD), et
    - que la seconde composante (R2) de la résistance est reliée au premier potentiel d'alimentation (VSS).

6. Circuit tampon intégré suivant la revendication 2 ou 3, caractérisé par le fait

    - que pour la production du potentiel de référence ($V_{ref}$) il est prévu au moins deux résistances (R1',R2') et au moins une diode (D),

- que les deux résistances (R1',R2') sont reliées, par leur extrémité tournée vers respectivement l'autre résistance (R2'; RI'), à la grille des transistors MOS (P2),
- que la ou les diodes (D) sont disposées entre la première résistance (RI') et le second potentiel d'alimentation (VDD), et
- que la seconde résistance (R2') est reliée au premier potentiel d'alimentation (VSS).

7. Circuit tampon intégré suivant la revendication 4 à 6, caractérisé par le fait que la diode (D) est une diode à jonction pn.

8. Circuit tampon intégré suivant l'une des revendications 4 à 6, caractérisé par le fait que la diode (D) est un transistor branché en diode.

9. Circuit tampon intégré suivant l'une des revendications 2 à 8, caractérisé par le fait qu'une première capacité ($C_{vss}$) est disposée entre la grille du transistor MOS (P2) et le premier potentiel d'alimentation (VSS).

10. Circuit tampon intégré suivant l'une des revendications 2 à 9, caractérisé par le fait qu'une seconde capacité ($C_{IN}$) est disposée entre l'entrée du premier inverseur (I1) et la grille du transistor MOS (P2).

11. Circuit tampon intégré suivant la revendication 9 ou 10, caractérisé par le fait qu'au moins l'une des capacités ($C_{VSS}$, $C_{IN}$) est un varactor MOS.

12. Circuit tampon intégré suivant l'une des revendications précédentes, caractérisé par le fait que le premier transistor à hystérèse (TNHy) est du type à canal n.

13. Circuit tampon intégré suivant l'une des revendications précédentes, caractérisé par le fait que le premier transistor à hystérèse (TNHy) possède un courant de saturation, qui est inférieur au courant de la source de courant constant (I).

14. Circuit tampon intégré suivant l'une des revendications précédentes, caractérisé par le fait qu'entre le noeud (1) du circuit et le second potentiel d'alimentation (VDD) est disposée la section de canal d'un second transistor à hystérèse (TPHy), dont la grille est reliée à la sortie du second inverseur (I2) .

15. Circuit tampon intégré suivant la revendication 14, caractérisé par le fait que le second transistor à hystérèse (TPHy) est du type à canal p.

16. Circuit tampon intégré suivant la revendication 14 ou 15, caractérisé par le fait que le rapport de la largeur à la longueur du canal du second transistor à hystérése (TPHy) est inférieur au rapport de la largeur à la longueur d'un transistor (N1) du premier inverseur (I1).

17. Circuit tampon intégré suivant l'une des revendications précédentes, caractérisé par le fait que les transistors Enable (EN1,EN2) ont des types de canal réciproquement opposés.

18. Circuit tampon intégré suivant l'une des revendications 1 à 16, caractérisé par le fait que les transistors Enable (EN1,EN2) possèdent le même type de canal et qu'un troisième inverseur (I3) est disposé entre l'entrée Enable (EN) et la grille de l'un (EN2;EN1) des deux transistors Enable (EN1,EN2).

# FIG 1

# FIG 2

FIG 3

FIG 4

FIG 5

EP 0 587 938 B1

FIG 7

FIG 6

# FIG 8

# FIG 9

# FIG 10

FIG 11

FIG 12